(19)

Europäisches
Patentamt
European
Patent Office
Office européen
des brevets

(11) **EP 1 692 732 B1**

(12) **EUROPEAN PATENT SPECIFICATION**

(45) Date of publication and mention
of the grant of the patent:
**08.10.2008 Bulletin 2008/41**

(51) Int Cl.:
***H01L 51/50*** (2006.01)

(21) Application number: **04799218.5**

(22) Date of filing: **23.11.2004**

(86) International application number:
**PCT/IB2004/052519**

(87) International publication number:
**WO 2005/055330 (16.06.2005 Gazette 2005/24)**

(54) **ELECTROLUMINESCENT DEVICE**

ELEKTROLUMINESZENZBAUELEMENT

DISPOSITIF ELECTROLUMINESCENT

(84) Designated Contracting States:
**AT BE BG CH CY CZ DE DK EE ES FI FR GB GR
HU IE IS IT LI LU MC NL PL PT RO SE SI SK TR**

(30) Priority: **02.12.2003 EP 03104494**

(43) Date of publication of application:
**23.08.2006 Bulletin 2006/34**

(73) Proprietor: **Koninklijke Philips Electronics N.V.
5621 BA Eindhoven (NL)**

(72) Inventors:
• **HIKMET, Rifat, A., M.
NL-5656 AA Eindhoven (NL)**
• **HOFSTRAAT, Johannes, W.
NL-5656 AA Eindhoven (NL)**

(74) Representative: **Reints Bok, Wouter
Philips
Intellectual Property & Standards
P.O. Box 220
5600 AE Eindhoven (NL)**

(56) References cited:
**WO-A-03/021694          WO-A-03/084292**

• **BAKUEVA L ET AL: "Size-tunable infrared
(1000–1600 nm) electroluminescence
from PbS quantum-dot nanocrystals in a
semiconducting polymer" APPLIED PHYSICS
LETTERS, AMERICAN INSTITUTE OF PHYSICS.
NEW YORK, US, vol. 82, no. 17, 28 April 2003
(2003-04-28), pages 2895-2897, XP012033900
ISSN: 0003-6951**
• **PATENT ABSTRACTS OF JAPAN vol. 2002, no.
02, 2 April 2002 (2002-04-02) -& JP 2001 279240 A
(TOSHIBA CORP), 10 October 2001 (2001-10-10)**

**Description**

BACKGROUND OF THE INVENTION

Organic electroluminescent devices are considered to be important in many applications ranging from lighting to full colour emissive displays. The basic structure is an emitting organic layer sandwiched between electrode layers and transport layers providing electrons and holes to the emitting layer.

In organic electroluminescent devices, electrons injected into lowest unoccupied molecular orbital (LUMO) of the emitting organic layer are combined with the holes injected into the highest occupied molecular orbital (HOMO) creating hole-electron pairs (excitons) which recombine to emit light. It is therefore important to have balanced injection of holes and electrons, which recombine within the emitting layer.

Organic light emitting materials, typically electroluminescent polymers, can be engineered to show both good electron as well as good hole transport. In addition, the HOMO and LUMO levels of electroluminescent polymers can be adjusted so that they can be used with commonly available cathode and anode materials (e.g., ITO anode, barium cathode). This results in simple three-layer structures (electrode - organic emitting layer - electrode), referred to as a polymer light emitting device PolyLED. Small organic molecules are also used in the production of electroluminescent devices, OLEDs. In the case of OLEDs usually more than three layers are used in order to improve the efficiency of the devices.

Recently, doping of organic materials with dyes has received much attention. Host materials with a large band gap can be doped with dyes with a smaller band gap. In a three-layer configuration, electrons and holes are injected into the polymer layer to create excitons, which may then be transferred to the dye molecules for emission. This allows for a very broad choice in emission wavelengths, as it becomes a matter of simply choosing the proper dye. To obtain effective energy transfer it is necessary to disperse the dye homogeneously within the emitting layer and to keep the dye molecules in close proximity to the organic host material, e.g. the polymer chains. For these reasons, dye molecules are often covalently attached to the polymer during synthesis.

However, because dye molecules often have limited stability, nano-sized semiconductor crystals referred to as quantum dots (QDs) have been proposed as a substitution for dyes in OLEDs and PolyLEDs. Here, quantum dots are mixed/blended with an organic host material to form an emitting matrix sandwiched between electrodes in a layered structure, a QD-OLED or PolyLED. Such devices are described in e.g. "Quantum dot leap", The Engineer (ISSN 0013-7758) 291, 19, 2002 and "Quantum-dot composite LED emits in IR", Photonics Technology World, June 2003 (http:/www.photonics.com/ spectra/ tech/XQ/ASP/ techid. 1557/QX/ read.htm). Electrons and holes injected into the matrix create excitons in the polymers, which are transferred to the QDs for recombination and light emission. Besides better stability, QD provides a number of advantages over dyes. Although reactive, it is relatively easy to encapsulate QD in a "passivation" or "capping", layer for making them resistant to air and humidity. Also, QDs have the unique property of emitting light at a frequency determined by their size. Thus, the emission wavelength from QDs can be precisely and continuously tuned over a large span of wavelengths simply by adjusting their size during fabrication.

One disadvantage of using QDs as compared with dyes is that exciton transfer to quantum dots is more difficult. Delocalised $\pi$ molecular orbitals in conjugated hydrocarbon chains in the organic molecules and in polymers provide efficient transportation of electrons, holes and excitons. The injection of holes and electrons creates excitons at random locations within the emitting layer, often far away from the QD. Also, electrons and holes may be transported in the organic host material and recombine at the QDs without proper exciton formation. The good electron and hole transport allows for the creation and transport of excitons in the layer, but the coupling of excitons from the electroluminescent material into the QDs presents a bottleneck.

QD-OLEDs or PolyLEDs are not to be confused with other types of LEDs featuring QDs, where a thin layer of QDs are sandwiched between organic semiconductor (hole and electron) transportation layers. Here, electrons and holes are supplied directly to the QDs or the capping molecules on the QDs, not in an organic host material, and hole/electron and exciton transport or decay is not an issue.

WO 03/021694 describes an electroluminescent device wherein the device is characterized by a light emitting layer comprising quantum dots. The quantum dots are provided with capping molecules with functional units on the quantum dot surfaces which cause excited state injection into the quantum dots. The capping molecules with functional units comprise exciton transport moieties, which cause the injection of excitons to the core of the quantum dots.

WO 03/084292 describes an electrically pumped light emitting devices including nanocrystals (or quantum dots) as the electroluminescent material. The described light emitting device includes a first electrode, a layer including a in a matrix, a first electrode, a second electrode opposed to the first electrode and a plurality of semiconductor nanocrystals disposed between the first electrode and the second electrode. The matrix can be non-polymeric, for example, a small molecule.

SUMMARY OF THE INVENTION

It is an object of the present invention to improve electrical energy transfer from electroluminescent organic materials to QDs embedded in these.

In a first aspect, the invention provides a method for improving electrical energy transfer from electroluminescent organic molecules to quantum dots embedded in an organic material matrix, the method comprising the steps of

- providing a matrix of electroluminescent organic molecules with embedded quantum dots,
- providing one or more phosphorescing transfer molecules on the surfaces of the quantum dots,
- supplying electrons and holes to the matrix using first and second electrical contacts in electrical contact with the organic matrix,
- generating excited states in the electroluminescent organic molecule of the matrix in the form of excitons,
- transferring excitons from the electroluminescent organic molecule to the phosphorescing transfer molecules on the quantum dots, and
- transferring excitons from the phosphorescing transfer molecules to the quantum dots.

The embedding of QDs in the matrix means that the QD are spatially distributed throughout the organic matrix. The QDs are preferably at least substantially homogeneously distributed in the organic matrix. The spatial distribution may be random or ordered, or anything in between. The QDs are preferably bound or in close contact to the organic molecules by some at least substantially bond-like interaction. Preferably, the QDs are embedded in the organic host material, and therefore form a single, QD-doped, emissive layer.

A matrix of electroluminescent organic molecules, preferably polymers, with embedded QDs is typically formed by blending or mixing liquid solutions of organic molecules and the QDs. The resulting solution may be deposited on a substrate, typically by spin-coating, such as an electrode and allowed to dry out, thereby forming the matrix. Transfer molecules will typically be provided on the surfaces of the QDs before the QD solution is mixed into the organic solution.

The electroluminescent organic molecules may be any of the electroluminescent organic substances presently used in OLEDs and PolyLEDs. However, in order to form a suitable organic matrix, the substance is preferably soluble or can be modified to be soluble. This allows for the proper embedding of the QDs in the organic matrix. A further advantage of such substances is that they can be processed from solution, so that the emissive layer can be readily patterned for multi- or full colour emission. Further, the organic host material and QD solution may only be partially dried out, so that a fluid emissive layer may be formed.

Preferably, the electroluminescent organic molecules according to the invention are electroluminescent polymers. Polymers are organic molecules, and both "organic molecules" and "polymers" will be used to designate the matrix host material of the light emitting layer in the following description, without the intention of limiting the scope to polymers only.

Even though the organic molecules provides efficient exciton transport, the lifetime of excited states or excitons in the electroluminescent organic molecules is not long enough for the exciton transfer to the QDs to take place. While excited states directly on the surface of the quantum dots show almost 100% energy transfer, this value reduces to about 10% already at a distance of 3nm from the surface of the quantum dots. Because of this behavior the excitons need to be brought to a closer proximity to the quantum dots in order to increase the energy transfer rate. This can be achieved by placing an exciton recombination and/or transfer molecule on the surface of the quantum dot. However it is still necessary to transfer the excited state created in the organic matrix to the transfer molecule. According to the theory of Förster for resonant energy transfer in the presence of a nearby (acceptor) molecule having an absorption spectrum overlapping the donor emission spectrum, part of the energy absorbed by the donor is transferred non-radiatively to the acceptor with an efficiency E given by

$$E = \left(1 + \left(\frac{r}{R_o}\right)^6\right)^{-1},$$

where $r$ is the distance between the two emitting centers and $R_0$ is the Förster radius (in Å):

$$R_0 = a(\kappa^2 n^{-4} Q_D J(\lambda))^{1/6}.$$

In this complex expression, $a = 9.78 \times 10^3$, n is the refractive index of the medium, $Q_D$ the donor fluorescence quantum yield in the absence of the acceptor and $J(\lambda)$ is a spectral overlap integral (in $M^{-1} \cdot cm^3$). $k^2$ is a geometric factor, which averages out to 2/3 in the case of freely rotating dyes.

Alternatively, the transfer efficiency can be measured via the fluorescence lifetimes as

$$E = (1 - \tau_{D(A)}/\tau_{D(0)}),$$

where $\tau_{D(A)}$ and $\tau_{D(0)}$ are the donor lifetimes in the presence or absence of acceptor, respectively. Therefore when an energy transfer molecule with a very large Förster radius is used the energy can very effectively be transferred from the organic matrix to the exciton transfer molecule which in a second step transfers the energy to the quantum dot.

In order to utilize both Förster and Dexter energy transfer in dye doped systems, a proper guest-host system must be selected. With a highly efficient emitting guest, the energy levels of both singlet and triplet excitons in the host must lie above the corresponding levels in the guest, and efficient energy transfer requires an overlap of emission in the host and absorption in the guest for both Förster and Dexter transfers to work out. The efficiency of either Förster or Dexter energy transfer from the host can also be described by

$$E = \frac{k_{ET}}{k_{ET} + k_R + k_{NR}} \; .$$

Here $k_{ET}$ is the rate of energy transfer from the organic molecule to the energy transfer molecule and $k_R$ and $k_{NR}$ are the radiative and nonradiative rate of the donor, respectively. This equation suggests that energy transfer is efficient if $k_{ET} > k_R + k_{NR}$. While the Förster energy transfer between singlet excitons takes place in the nanosecond time scale, the triplet-triplet Dexter energy transfer is often in the microsecond range. Therefore the exciton lifetime must be longer than the microsecond range to have an efficient triplet-triplet energy transfer by the Dexter mechanism.

A transfer molecule is a molecule capable of receiving an exciton from an organic molecule, preferably a polymer of the matrix and transfer an exciton to the QD. In another formulation, a transfer molecule is a molecule which can be excited by an excited state in an organic molecule of the matrix, e.g. by exchange interaction (Dexter energy transfer) or by more long-range dipolar interactions (Förster energy transfer), and which excited transfer molecule can excite the QD by a similar mechanism.

Preferably, a transfer molecule is selected to have a bandgap, $E_{transfer}$, which is smaller than a bandgap, $E_{org. mol.}$, of the electroluminescent molecules of the matrix and larger than a bandgap, $E_{QD}$, of the quantum dots. To ensure an efficient transfer of excitons from the organic molecules to the transfer molecule, the excitons should be transferred before they decay or recombine in the organic molecules. Hence, a transfer molecule is preferably selected so that a transfer rate of excitons from the electroluminescent organic molecules s to the transfer molecules is larger than the decay rate of excitons in the electroluminescent host.

Similarly, the exciton should be transferred from the transfer molecule to the QD before it decays or recombines in the transfer molecule. Hence, a transfer molecule is preferably selected so that a transfer rate of excitons from the transfer molecules to the quantum dots is larger than a decay rate of excitons in the transfer molecules. Optionally, a transfer molecule is a phosphorescing molecule having excitable long lived excited triplet states, i.e. excitons will have small decay/recombination rates.

The transfer molecules can be chosen so that they have a minimal distance to the QD and to the electroluminescent organic host molecules. The two-step energy transfer process makes it possible to reduce - indirectly - the effective distance between the QD and the organic molecules. Care should be taken to avoid too many of these molecules are present on the surface, so that concentration quenching is avoided.

In a second aspect, the invention provides a quantum dot embedded organic material device with improved electrical energy transfer from electroluminescent organic molecules to embedded quantum dots, the device comprising

- a matrix of electroluminescent organic molecules embedded with quantum dots, and
- first and second electrical contacts for supplying electrons and holes to the matrix, wherein a quantum dot has one or more phosphorescing transfer molecules attached to its surface for receiving excitons generated in the electroluminescent organic molecules and transferring received excitons to the quantum dot, the phosphorescing transfer molecules being chosen so that a transfer rate of excitons from the electroluminescent organic molecules to the phosphorescing transfer molecules is larger than a decay rate of excitons in the electroluminescent organic molecules.

Further, the one or more transfer molecules are preferably chosen so that a transfer rate of excitons from the transfer molecules to the quantum dots is larger than a decay rate of excitons in the transfer molecules.

Preferably, the device according to the second aspect is a light emitting device, i.e. a QD-PolyLED. Using such a device, a layered structure can be produced where the excitons are first created on the polymer, subsequently transferred to surface modifying molecules, and finally to the quantum dot where the emission takes place.

When a polymeric host is used, the HOMO and LUMO levels of electroluminescent polymers can be adjusted, so that they can be used with commonly available cathode and anode materials, such as an ITO anode and a barium cathode, so as to form a three layer structure. In a preferred embodiment, the light emitting device comprises one or more further layers such as a hole transporting and electron blocking layer and/or a electron transporting and hole blocking layer in addition to the organic emitting layer. Such layers, located between the respective electrodes and the organic matrix, serves to provide efficient hole/electron transport from the cathode/anode into the light emitting layer, while confining the excitons in the emitting layer In the ideal case the electron transport (hole blocking) layer is placed at the cathode side and would have a LUMO level which is the same as that of the organic matrix and a HOMO level preferably lower than that of the organic matrix. Such a material is also expected to show much higher electron mobility than hole mobility. The ideal hole transport (electron blocking) layer is placed at the anode side on the other hand would have a LUMO level which is higher than that of the organic matrix and a HOMO level preferably slightly lower than that of the organic matrix while being higher than the fermi level of the anode. Such a hole transport (electron blocking) layer is also expected to show much higher hole mobility than electron mobility.

A well-known example of such an additional layer which is also used as planarisation layer is the PEDOT/PSS hole transport layer, which is applied between the ITO anode and the organic emitting layer. Thus, the method according to the first aspect of the invention may comprise the step of confining electrons and holes in the matrix by providing electron and hole blocking layers adjacent to the matrix.

The invention may be applied in a display comprising a plurality of pixels, each pixel comprising a light emitting quantum dot embedded organic molecule device according to the second aspect of the invention. In a preferred embodiment, the display is active in that an on/off state of each pixel can be controlled individually. In another preferred embodiment, the display is a colour display in that the pixels have different colours, such as two or more different colours, e.g. red, green and blue. The colour of a pixel is determined by the bandgap, and thereby the size, of the quantum dots embedded in the light emitting layer of the pixel.

In a third aspect, the invention provides a process for fabricating a light emitting quantum dot embedded organic device with improved electrical energy transfer from electroluminescent organic molecules to quantum dots, the process comprising the steps of:

a) providing a plurality of electroluminescent organic molecules in solution,
b) providing a solution comprising a plurality of quantum dots with one or more phosphorescing transfer molecules attached to the surfaces, the phosphorescing transfer molecules having a bandgap, $E_{transfer}$, which is smaller than a bandgap, $E_{org. mol.}$, of the electroluminescent organic molecules and larger than a bandgap, $E_{QD}$, of the quantum dots,
c) mixing the electroluminescent organic molecule solution with the quantum dot solution,
d) providing a first electrical contact,
e) forming a matrix of electroluminescent organic molecules with embedded quantum dots on the first electrical contact by depositing the mixed solution on the electrical contact, and
f) depositing a second electrical contact on the matrix.

Optionally, the process further comprises one or more of the following steps:

- Planarising the contact using a conducting material layer.
- Forming, between the matrix and the first or second electrode, a material layer for enhancing hole transport and deteriorating or blocking electron transport.
- Forming, between the matrix and the second or first electrode, a material layer for enhancing electron transport and deteriorating or blocking hole transport.

The principle behind the above aspects of the invention is to use a two-step energy transfer process to improve electrical energy transfer from electroluminescent organic molecule s to quantum dots embedded therein. It is clear from the above that the nonradiative energy transfer is inversely proportional with the distance between the emitting centres, the efficiency of the exciton transfer to the QDs decreases non-linearly with increasing distance. By introducing an intermediate stage, the transfer molecule attached to the QD, two shorter transitions is obtained instead of one long. The overall efficiency is then improved due to the non-linear dependence of the energy transfer on distance.

The invention may be applied to improve the power efficiency and performance of all devices based on an electroluminescent organic matrix with embedded QDs. The invention may thus lead to the use of such devices in a large number of applications where other light emitting devices are presently used. Also, it may lead to the use of such devices in areas into which the present efficiency of electrical energy transfer have impeded the possibility of migration of this technology. Thus, the invention is not restricted to improve light emitting devices, but may be used to improve the power efficiency and performance of devices based on an organic matrix with embedded QDs in other areas, such as micro/nanoelectronic components, sensors, photovoltaic devices, and other non-emissive devices.

These and other aspects of the invention will be apparent from and elucidated with reference to the embodiment(s) described hereinafter.

BRIEF DESCRIPTION OF THE DRAWINGS

Figure 1 shows a cross-sectional view of a light emitting device according to a preferred embodiment of the invention.

Figure 2 shows an enlarged cross-sectional view (not to scale) of a QD embedded matrix of polymers.

Figure 3 shows an enlarged cross-sectional view (not to scale) of a QD with transfer molecules.

Figures 4A-J show a number of triplet emitters based on Iridium, and platinum complexes which may be used as transfer molecules according to the invention.

Figure 5 shows a cross-sectional view of a light emitting device comprising electron/hole blocking, hole/electron transporting layers according to a preferred embodiment of the invention.

Figure 6 shows a cross-sectional view of an active colour display according to an embodiment of the invention.

Figure 7 shows the molecular formula of an anthracene derivative.

Figure 8 is a graph showing emission and excitation spectra of QDs and an anthracene derivative.

Figure 9 is a graph showing emission and excitation spectra of QDs and an anthracene derivative.

Figure 10 is a graph showing emission spectra of QDs and a triplet emitter.

Figure 11 is a graph showing excitation spectra of QDs and a triplet emitter.

Figure 12 is a graph showing decays of QDs and a triplet emitter.

DESCRIPTION OF THE PREFERRED EMBODIMENTS

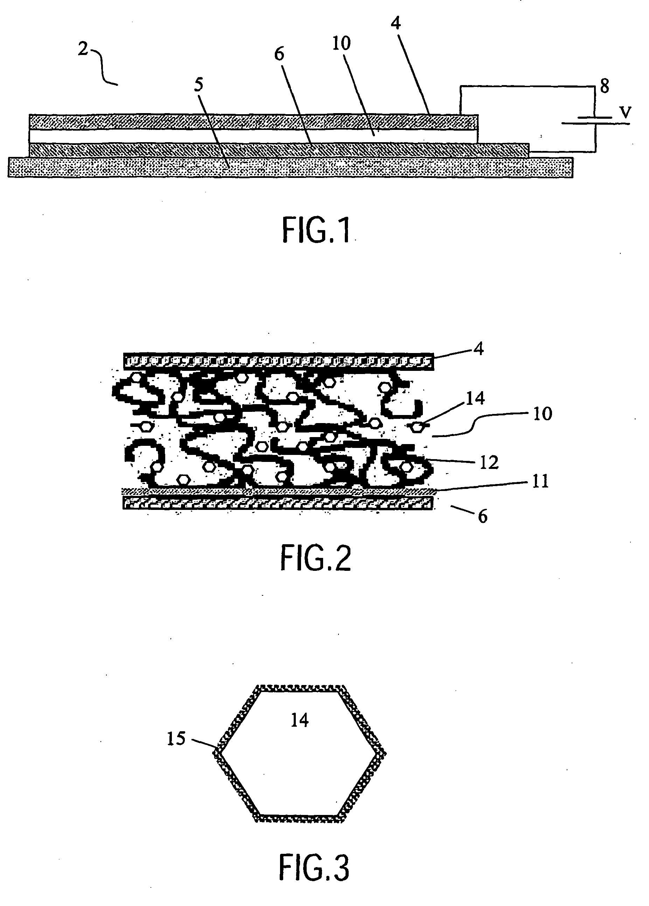

In a preferred embodiment shown in Figure 1, the invention provides a light emitting device 2. The device comprises a cathode 4 and a transparent anode 6 on a transparent substrate 5 with a power supply 8 for creating an electrical field between these. Between the electrodes is a light emitting layer 10 consisting of a blend of electroluminescent organic molecules and QDs. In the described embodiments, the organic molecules are polymers.

Figure 2 shows an illustration of an enlarged section of the device 2 of Figure 1, the figure exaggerates the relative size. Here, the light emitting layer 10 is seen to consist of a matrix of polymers 12 with QDs 14 with transfer molecules distributed throughout the matrix. Also, a thin film planarising layer 11 is seen between the anode 6 and the light emitting layer 10.

In the following, a preferred method of fabrication of the light emitting device 2 of Figures 1 and 2 is described. When designing the device 2, the electrode work functions should match the HOMO and LUMO levels in the polymer so that it is easy to inject a steady supply of electron and hole pairs into the polymer. For the anode 6, a thin layer of transparent conductor indium tin oxide (ITO) is deposited on the glass or plastic substrate 5. A thin film planarising layer 11, typically 50 to 150-nm thick, is deposited on the anode 6 from solution using e.g. spin coating or a printing technique. The planarising layer is a non-emissive conducting polymer, poly-ethylenedioxythiophene (PEDOT) or polyaniline doped with poly-styrenesulphonic acid (PSS), which serves as a hole-injecting layer and has an even higher work function than ITO. To form the light emitting layer 10, a solution of electroluminescent polymers and QDs is deposited on the planarising layer 11 using e.g. spin coating or a printing technique. Preparation of the polymer and QD solution will be described later. Finally, a metallic cathode 4 is evaporated on top of the emissive layer 10. The cathode 4 is a reflective metal layer with a low work function to match the LUMO level of the polymer-for example, calcium or barium. Alternative fabrication techniques and structures are possible.

In PolyLED devices, the difference in work function between the cathode and anode materials is typically less than the polymer bandgap. Thus, there is an energy barrier preventing the electrons and holes entering the polymer, which impairs exciton generation, reducing efficiency. This potential energy barrier to charge injection is usually present at the cathode/polymer interface. One solution to this problem is to insert a thin layer of dielectric, such as lithium fluoride, at the cathode, which enhances electron injection and improves device efficiency.

The device is typically hermetically sealed to prevent the ingress of water and oxygen that can degrade the organic materials and the reactive metal cathode. Present-generation structures typically use a metal or glass can encapsulation, with a glue seal to the substrate.

The organic matrix forming the light emitting layer is formed when a mixture of organic molecules and QD solutions are deposited and the solvent evaporated. Typical electroluminescent polymers and oligomers are poly- or oligo p-phenylene vinylene (PPV) and the poly- or oligofluorene family (e.g. poly(9,9'-dioctylfluorene)). Other electroluminescent polymers comprise poly- or oligo-phenylenes, poly- or oligo-phenylethylenes, poly- or oligo-indenofluorenes, poly- or oligo-vinylcarbazoles, poly- or oligo-oxadiazoles, and copolymers or blends thereof. It is also possible to use small organic molecules with suitable side groups for solubility and film forming. They can also be in the form of highly branched molecules such as dendrimers in order to improve their solubility as well as film forming properties. Examples of such small molecules are a fluorene, a fluorene derivative, a perylene, a perylene derivative, a coumarine, a coumarine derivative, a phenoxazone, a phenoxazone derivative, 4-dicyanmethylene-2-methyl-6- (p-dimethylaminostyryl)-4H-pyran (DCM), a 4-dicyanmethylene-2-methyl-6-(p-dimethylaminostyryl)-4H-pyran derivative, a rhodamine, a rhodamine derivative, an oxazine, an oxazine derivative, an oxazole, an oxazole derivative, a styryl, a styryl derivative, a metal-organic complex, a stilbene, a stilbene derivative, a flavin, a flavin derivative, a fluorescein, a fluorescein derivative, a pyrromethene, a pyrromethene derivatives or any other dye. Triplet emitters based in Iridium, and platinum complexes can also be used.

These systems may also contain electron and/or hole conducting moieties listed below in order to improve charge transport within them. It is possible to tune the electrical properties of band gap, electron affinity, and charge transport, and rheological properties such as viscosity and solubility by various substitutions, thus tailoring the material to the specific application and deposition method.

A QD 14 with transfer molecules 15 is shown in Figure 3. The QDs are preferably prepared by wet chemical processes, and transfer molecules 15 are added to the surface after formation of the QD. QDs are semiconductor nanometer crystals and may comprise Group [II-VI] semiconductor compounds such as MgS, MgSe, MgTe, CaS, CaSe, CaTe, SrS, SrSe, SrTe, BaS, BaSe, BaTe, ZnS, ZnSe, ZnTe, CdS, CdSe, CdTe, HgS, HgSe and HgTe; and/or crystals of Group [III-V] semiconductor compounds such as GaAs, GaP, InN, InAs, InP and InSb; and/or crystals of group IV semiconductor compounds such as Si and Ge. In addition, the semiconductor compounds may be doped with rare earth metal cations or transition metal cations such as $Eu^{3+}$, $Tb^{3+}$, $Mn^{2+}$, $Ag^+$ or $Cu^+$. It may be possible that a QD consists of two ore more semiconductor compounds. Most likely the QDs comprise InN, InGaP or GaAs. The radii of the QDs are smaller than the exciton Bohr radius of the respective bulk material. Most likely the QDs have radii no larger than about 10 nm.

It is possible that the QDs comprise a core-shell structure. In this case, a QD consists of light emitting core material, e.g. CdSe overcoated with a shell material of higher bandgap, e.g. ZnS, such that an exciton is confined to the core of the QD.

Colloidal luminescent CdSe/ZnS core-shell nanocrystals can be synthesized via two-stage approach. At the first stage the monodisperse CdSe nanocrystals are prepared by reacting dimethylcadmium with trioctylphosphine selenide in hexadecylamine - trioctylphosphine oxide - trioctylphosphine (HDA-TOPO-TOP) stabilising mixture at 270-310°C. The ZnS shell around the colloidal CdSe cores are grown by slow addition of dimethylzinc and bis-trimethylsilylsulfide (zinc and sulphur precursors correspondingly) into the solution of CdSe cores in HDA-TOPO-TOP mixture at 180-220°C. The resulting CdSe/ZnS core-shell nanocrystals have a HDA-TOPO-TOP surface coating and are soluble in non-polar solvents like chloroform or toluene.

Core-shell CdSe/ZnS nanocrystals exhibit strong band-edge photoluminescence with room temperature quantum efficiencies as high as 30-70%. The spectral position of the emission band is tuneable from blue to red with increasing the size of CdSe core from ~2 to 6 nm Thin (~2 monolayers) ZnS epitaxial shell grown around CdSe core considerably improves particle stability and the luminescence efficiency.

The surface of the particles can be modified using other molecule resulting in total or partial replacement of HDA-TOPO-TOP. In order to modify the surface of the dots with transfer molecules, they can be subjected to standard capping exchange procedure. An excess amount of transfer molecules with suitable functional groups are added to the QD solution in chloroform and stirred at 50 °C for several hours. Methanol can be used to precipitate the QDs. The dissolution and precipitation steps are repeated several times in order to remove transfer molecules which were not bound to QD surfaces. The transfer molecules can be chosen to have a small distance to the QD by introduction of a functional group which attaches directly to the surface of the QD, e.g., through a carboxylate, phosphonate, sulphonate or thiol-group.

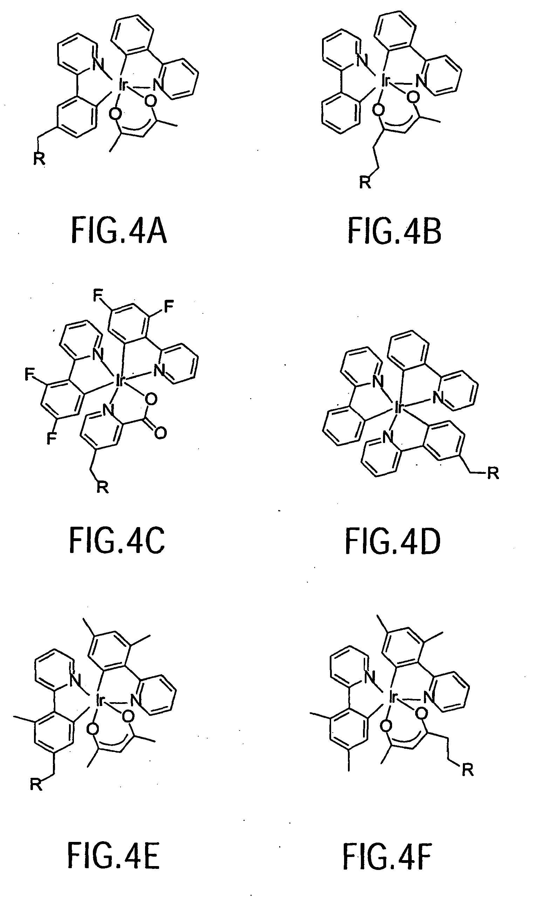

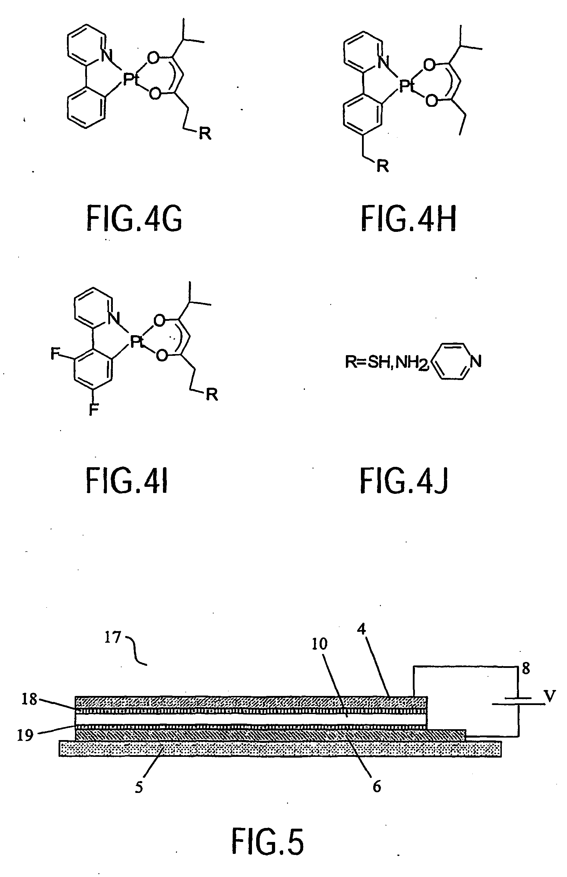

Preferably, triplet emitters based in Iridium, and platinum complexes such as those shown in Figures 4A-J can be applied as transfer molecules.

In order to confine electrons and holes in the organic matrix for exciton formation, electron/hole blocking layers preventing conduction of electrons/holes through the organic matrix may also be formed. Figure 5 shows a device 17 similar to the device 2 in Figure 1 with such layers. Between cathode 4 and organic matrix 10, a hole transporting and electron blocking layer 19 is formed. Similarly, an electron transporting and hole blocking layer 18 is formed between anode 6 and organic matrix 10.

Hole transporting, electron bloeking material layer 19 may comprise a tertiary aromatic amine, a thiophene oligomer, a thiophene polymer, a pyrrol oligomer, a pyrrol polymer, a phenylenevinylene oligomer, a phenylenevinylene polymer, a vinylcarbazol oligomer, a vinylcarbazol polymer, a fluorene oligomer, a fluorene polymer, a phenylenethyne oligomer, a phenylenethyne polymer, a phenylene oligomer, a phenylene polymer, an acetylene oligomer, an acetylene polymer, a phthalocyanine, a phthalocyanine derivative, a porphyrine or a porphyrine derivative. One or more carbon atoms of the oligomers or polymers may also be substituted. Such a material layer may also comprise molecules with a functional unit such as a triphehyl amine unit, a phenylenevinylene oligomer unit, a phenylene oligomer unit or a fluorene oligomer unit. In addition, dyes having the highest occupied molecular orbital (HOMO) within the range of about four and about six eV can be used as hole transporting, electron blocking material layer 19.

Electron transporting, hole blocking material layer 18 may comprise an oxadiazole, an oxadiazole derivative, an oxazole, an oxazole derivative, an isoxazole, an isoxazole derivative, a thiazole, a thiazole derivative, an isothiazole, an isothiazole derivative, a thiadiazole, a thiadiazole derivative, a 1,2, 3 triazole, a 1,2,3 triazole derivative, a 1,3,5 triazine, a 1,3, 5 triazine derivative, a quinoxaline, a quinoxaline derivative, a pyrrol oligomer, a pyrrol polymer, a phenylenevinylene oligomer, a phenylenevinylene polymer, a vinylcarbazol oligomer, a vinylcarbazol polymer, a fluorene oligomer, a fluorene polymer, a phenylenethyne oligomer, a phenylenethyne polymer, a phenylene oligomer, a phenylene polymer, a thiophene oligomer, a thiophene polymer, an acetylene polymer or an acetylene oligomer. One or more carbon atoms of the oligomers or polymers may also be substituted.

For the optimum performance the electron transport (hole blocking) layer needs to have a LUMO which is almost the same as that of the host organic material where the QDs are buried while the hole transport (electron blocking) layer needs to have a LUMO which is almost the same as that of the host organic material. In both cases hole and electron transport layers that the band gap is in the order of 6eV. These layers can be deposited from a solution, by physical or chemical vapour deposition. When solution deposition is used it is necessary to use a solvent which will not dissolve the layers

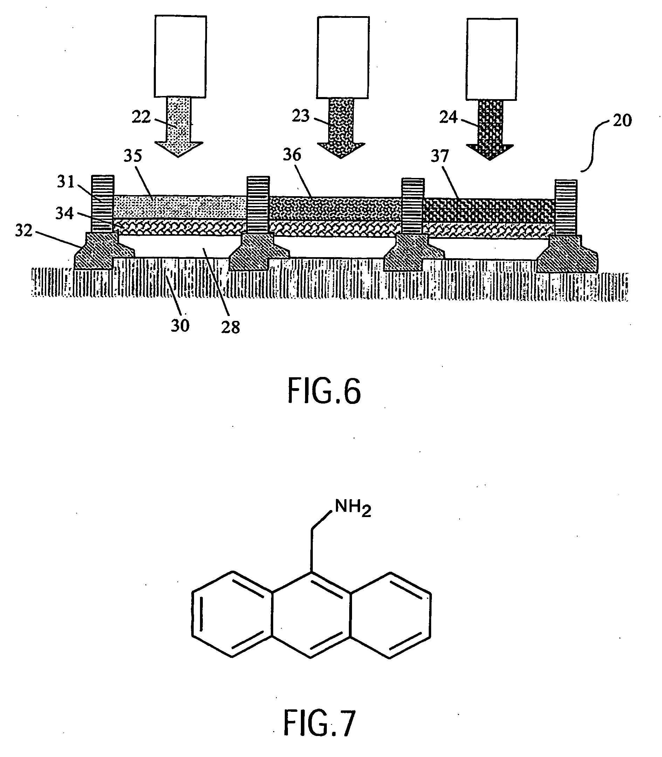

In the following section, a possible application of the light emitting device of the preferred embodiment is given. Here, the invention is used to form a plurality of light emitting devices forming a pixel array in an active colour display. Figure 6 shows a standard colour display design 20 which can be used to form a colour display using the highly efficient organic matrix with embedded QDs according to the present invention. Here, a pattern of individual red, green and blue pixels are formed, typically by printing the organic and QD mixture solutions 22, 23 and 24 directly into pre-patterned wells. Three different organic material and QD mixture solutions 22, 23 and 24 are needed, each having the QD-size tuned to create emission at an appropriate red, green or blue wavelength. Each pixel corresponds to the device 2 described in relation to Figure 1. Typically a transparent anode 28 is formed on top of a polysilicon TFT substrate 30 forms the bottom of the well, while a polyimide layer 31 on top of an insulating silica separator 32 forms the barriers. A planarising and hole-injecting PEDOT layer 34 is deposited on the anode 28. When the solute of the organic material and QD mixture solutions 22, 23 and 24 evaporate, the organic matrices 35, 36 and 37 with red, green and blue light emitting QDs are formed.

The active colour display described in relation Figure 6 is only one out of many possible applications of the present invention. Because of the improved power efficiency and performance of devices based on an electroluminescent organic matrix with embedded QDs according to the invention, a new freedom in the design of active and passive displays is obtained. Pixels can be made smaller and odd-shaped with low power needs giving rise to increased resolution. Further, flexible sheet displays and "electronic or digital paper" may be realised.

A series of measurements were carried out in order to illustrate the working principle of the energy transfer from transfer molecules to QDs according to the invention. The following fluorescence measurements illustrate the second step of the two step energy transfer of the invention.

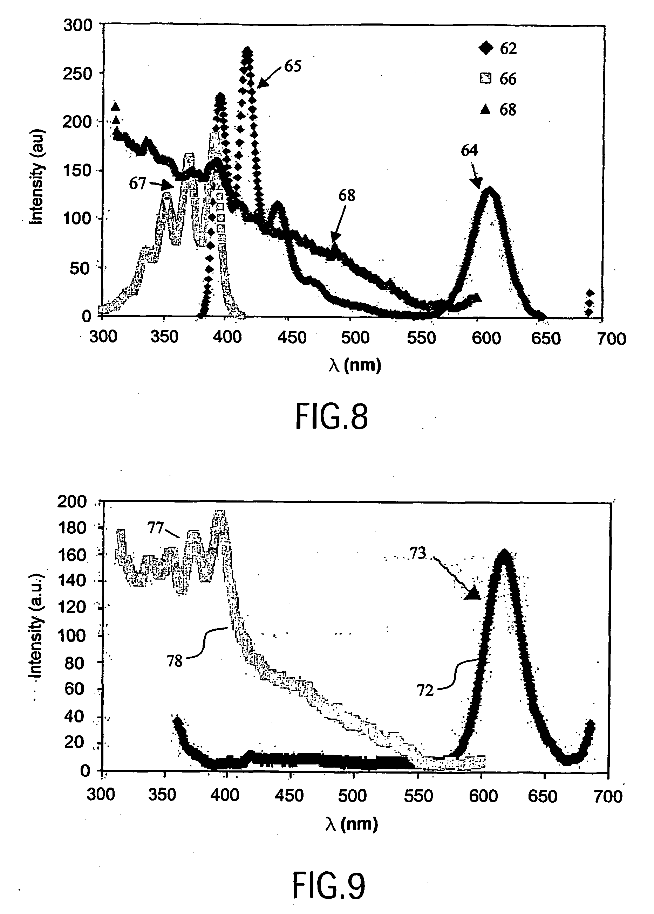

The first series of measurements shown in Figures 8 and 9 illustrates the energy transfer between a transfer molecule and QDs using excitation spectra from two scenarios; 1) with the transfer molecule not being attached to the QD and 2) with the transfer molecule being attached to the QD.

The transfer molecule selected for these measurements was the anthracene derivative shown in Figure 7 (not part of the invention).

Scenario 1); QDs and anthracene derivative in (same) solution. In Figure 8, the emission spectrum 62 from excitation of the solution at 360nm (where both QDs and anthracene derivative absorb) shows emission peaks for QD 64 and for anthracene derivative 65.

Spectrum 66 is an excitation spectrum corresponding to anthracene emission at 440nm. Here, the emission at 440nm (coming from anthracene) is monitored while the excitation wavelength is scanned. The resulting spectrum shows the strength of the 440nm emission as a function of excitation wavelength, thereby indicating how much of the excitation at a given wavelength results in emission at 440nm. The excitation peaks 67 are the anthracene excitation spectrum.

Also shown in Figure 8 is an excitation spectrum 68 corresponding to QD emission at 610nm. It can be seen that the 610nm emission mainly corresponds to QD absorption. The absence of the anthracene absorption peaks 67 in this spectrum indicates that there is almost no energy transfer from anthracene to QD.

Scenario 2); a dry film of QDs with attached anthracene derivative. Figure 9 shows the emission spectrum 72 from excitation of the film at 360nm, corresponding to emission spectrum 62 of Figure 8. The spectrum 72 shows emission peak 73 for QD but almost no emission from anthracene. Hence, when the sample is excited at 360nm, only emission from QD and no emission for anthracene is observed, this indicates that any absorption in anthracene is not re-emitted from anthracene.

Figure 9 also shows an excitation spectrum 78 corresponding to QD emission at 610nm, similar to the excitation spectrum 68 of Figure 8. Excitation spectrum 78 clearly shows anthracene absorption peaks 77 superimposed on the QD absorption. This proves that anthracene absorption contributes to the 610nm QD emission, and clearly indicates the presence of energy transfer from anthracene to QDs.

The measurements of Figures 8 and 9 illustrate the second step of the two step energy transfer, transfer of excitons from the transfer molecule to the QD. The behaviour observed for the dry film is totally different than the behaviour observed for the solution. In the dry film, excitons created in the transfer molecule are transferred to the QD at a rate which is larger than their decay rate in anthracene.

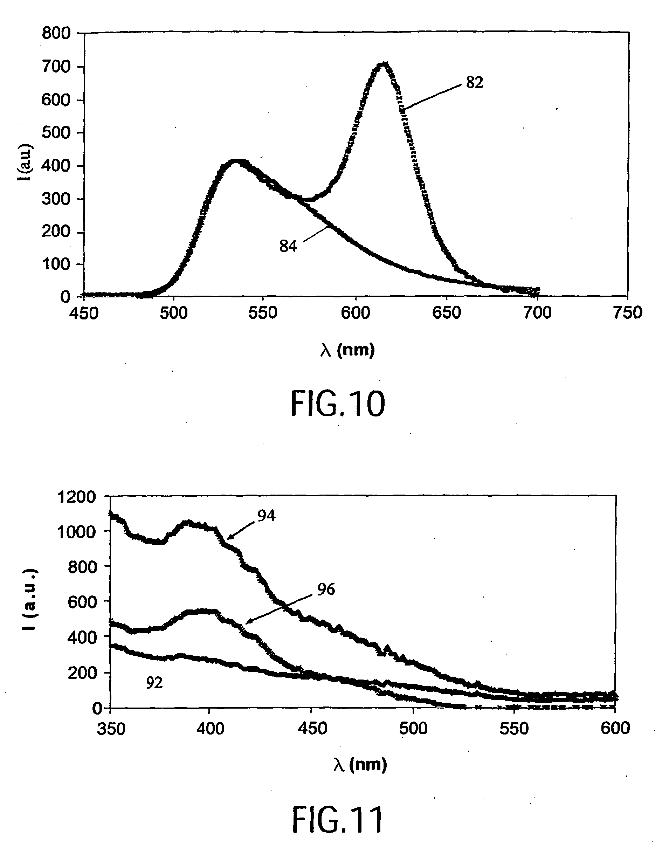

Another way of obtaining more efficient energy transfer from a molecule to a QD is by increasing the lifetime of the excited state in the transfer molecule. In this way more time will be available for the energy transfer from the molecule to the QD to take place. Hence, the second series of measurements shown in Figures 10, 11 and 12 illustrates the energy transfer between organic triplet emitters and QDs.

For this purpose we used triplet emitters, which are known to have long decay times. In Figure 10, an emission spectrum 82 of a layer containing 80% QDs and 20% triplet emitter is shown together with an emission spectrum 84 from the pure triplet emitter.

In Figure 11, curve 92 shows an excitation spectrum for the 620nm emission peak of Figure 10, corresponding to the quantum dot emission, for a pure QD layer. Curve 94 also shows an excitation spectrum for the 620nm QD emission peak, but for the layer containing 80% QDs and 20% triplet emitter. It can be seen that there is a much larger contribution to the QD emission in the spectrum 94 for the layer containing 80% QDs and 20% triplet emitter, indicating that much of the 620nm emission originates in absorption in the triplet emitter. Figure 11 also shows curve 96 which is spectrum 94 corrected for the quantum dot absorption (spectrum 92) and for the triplet emitters contribution to the emission at 620nm (Spectrum 84 of Figure 10 shows that the triplet emitter also emits at 620nm, the monitored 620nm emission are corrected for this contribution). After these corrections, it can be seen that there is still a contribution by the triplet emitter to the QD emission.

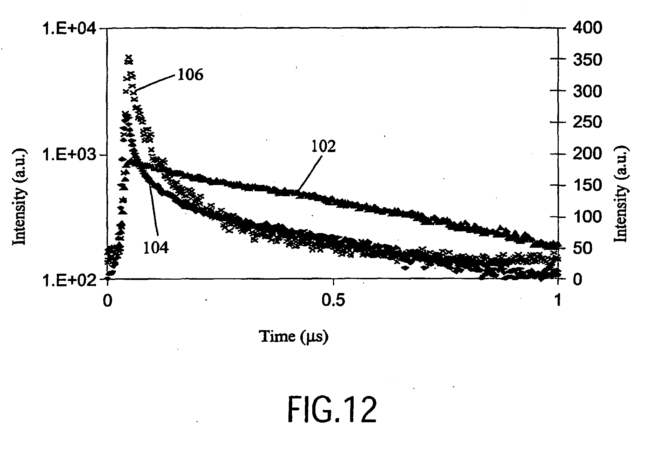

In order to prove energy transfer to quantum dots from the triplet emitter, time resolved measurements were performed. For this purpose, luminescence decay from the pure triplet emitter at 530 nm was measured as a function of time as shown on curve 102 in Figure 12. The same luminescence decay can be seen in curve 104, but for the layer containing 80% QDs and 20% triplet emitter. Here, it is clearly seen that the long decay time observed for the pure triplet emitter is drastically reduced upon mixing quantum dots into the system. In fact, the decay of curve 106 resembles the decay behaviour of the decay at 616nm shown in curve 106, primarily corresponding to QD emission.

The strongly reduced decay conclusively show that exciton transfer takes place from the triplet emitters to the quantum dots much faster than the decay of the triplet states, which result in increased QD emission.

**Claims**

1. A method for improving electrical energy transfer from electroluminescent organic molecules (12) to quantum dots (14) embedded in an organic material matrix, the method comprising the steps of

    - providing a matrix (10) of electroluminescent organic molecules with embedded quantum dots;
    - providing one or more phosphorescing transfer molecules (15) on the surfaces of the quantum dots,
    - supplying electrons and holes to the matrix using first and second electrical contacts (4,6) in electrical contact with the organic matrix,
    - generating excited states in the electroluminescent organic molecule of the matrix in the form of excitons,
    - transferring excitons from the electroluminescent organic molecule to the phosphorescing transfer molecules on the quantum dots, and
    - transferring excitons from the phosphorescing transfer molecules to the quantum dots.

2. The method according to claim 1, wherein the step of providing a matrix of electroluminescent organic molecules with embedded quantum dots, comprises the step of preparing the matrix from a solution of organic molecules and quantum dots.

3. The method according to claim 1, further comprising the step of confining electrons and holes in the matrix by providing electron and hole blocking layers adjacent to the matrix;

4. The method according to claim 1, wherein the step of providing one or more phosphorescing transfer molecules comprises a step of selecting phosphorescing transfer molecules which have a bandgap, $E_{tranfers}$, which is smaller than a bandgap, $E_{org.\ mol.}$, of the electroluminescent organic molecules and larger than a bandgap, $E_{QD}$, of the quantum dots.

5. The method according to claim 1, wherein the step of providing one or more phosphorescing transfer molecules comprises a step of selecting phosphorescing transfer molecules so that a transfer rate of excitons from the electroluminescent organic molecules to the phosphorescing transfer molecules is larger than a decay rate of excitons in the electroluminescent organic molecules.

6. The method according to claim 1, wherein the step of providing one or more phosphorescing transfer molecules comprises a step of selecting phosphorescing transfer molecules so that a transfer rate of excitons from the phosphorescing transfer molecules to the quantum dots is larger than a decay rate of excitons in the phosphorescing transfer molecules.

7. A quantum dot embedded organic molecules device (2) with improved electrical energy transfer from electroluminescent organic molecules (12) to embedded quantum dots (14), the device comprising

    - a matrix (10) of electroluminescent organic molecules embedded with quantum dots, and
    - first and second electrical contacts (4,6) for supplying electrons and holes to the matrix,

    **characterized in that**, a quantum dot has one or more phosphorescing transfer molecules (15) attached to its surface for receiving excitons generated in the electroluminescent organic molecules and transferring received excitons to the quantum dot, the phosphorescing transfer molecules being chosen so that a transfer rate of excitons from the electroluminescent organic molecules to the phosphorescing transfer molecules is larger than a decay rate of excitons in the electroluminescent organic molecules.

8. The device according to claim 7, wherein the one or more transfer molecules are chosen so that a transfer rate of excitons from the transfer molecules to the quantum dots is larger than a decay rate of excitons in the transfer molecules.

9. A process for fabricating a light emitting quantum dot embedded organic device (2) with improved electrical energy transfer from electroluminescent organic molecules (12) to quantum dots (14), the process comprising the steps of:

a) providing a plurality of electroluminescent organic molecules in solution.
b) providing a solution comprising a plurality of quantum dots with phosphorescing transfer molecules (15) attached to the surfaces, the phosphorescing transfer molecules having a bandgap, $E_{transfer}$, which is smaller than a bandgap, $E_{org.\,mol.}$, of the electroluminescent organic molecules and larger than a bandgap, $E_{QD}$, of the quantum dots,
c) mixing the electroluminescent organic molecule solution with the quantum dot solution,
d) providing a first electrical contact (6),
e) forming a matrix (10) of electroluminescent organic molecules with embedded quantum dots on the first electrical contact by depositing the mixed solution on the first electrical contact, and
f) depositing a second electrical contact (4) on the matrix.

10. The process for fabricating according to claim 9, comprising the steps of forming, between the matrix and the first or second electrode, a material layer for enhancing hole transport and deteriorating electron transport.

11. The process for fabricating according to claim 9, further comprising the steps of forming, between the matrix and the second or first electrode, a material layer for enhancing electron transport and deteriorating hole transport.

**Patentansprüche**

1. Verfahren zur Verbesserung der Übertragung elektrischer Energie von elektrolumineszenten, organischen Molekülen (12) zu in einer Matrix aus organischem Material eingebetteten Quantenpunkten (14), wobei das Verfahren die folgenden Schritte umfasst:

- Vorsehen einer Matrix (10) von elektrolumineszenten, organischen Molekülen mit eingebetteten Quantenpunkten,
- Vorsehen eines oder mehrerer phosphoreszierender Übertragungsmoleküle (15) auf den Oberflächen der Quantenpunkte,
- Zuführen von Elektronen und Löchern zu der Matrix unter Verwendung eines ersten und zweiten elektrischen Kontakts (4, 6) in elektrischem Kontakt mit der organischen Matrix,
- Erzeugen von angeregten Zuständen in dem elektrolumineszenten, organischen Molekül in der Form von Exzitonen,
- Übertragen von Exzitonen von dem elektrolumineszenten, organischen Molekül zu den phosphoreszierenden Übertragungsmolekülen auf den Quantenpunkten sowie
- Übertragen von Exzitonen von den phosphoreszierenden Übertragungsmolekülen zu den Quantenpunkten.

2. Verfahren nach Anspruch 1, wobei der Schritt des Vorsehens einer Matrix von elektrolumineszenten, organischen Molekülen mit eingebetteten Quantenpunkten den Schritt des Erzeugens der Matrix aus einer Lösung aus organischen Molekülen und Quantenpunkten umfasst.

3. Verfahren nach Anspruch 1, welches weiterhin den Schritt des Begrenzens von Elektronen und Löchern in der Matrix durch Vorsehen von Elektronen- und Löcherblockschichten in Angrenzung an die Matrix umfasst.

4. Verfahren nach Anspruch 1, wobei der Schritt des Vorsehens eines oder mehrerer phosphoreszierender Übertragungsmoleküle einen Schritt des Auswählens von phosphoreszierenden Übertragungsmolekülen umfasst, welche einen Bandabstand, $E_{transfer}$, aufweisen, der kleiner als ein Bandabstand, $E_{org.mol.}$, der elektrolumineszenten, organischen Moleküle und größer als ein Bandabstand, $E_{QD}$, der Quantenpunkte ist.

5. Verfahren nach Anspruch 1, wobei der Schritt des Vorsehens eines oder mehrerer phosphoreszierender Übertragungsmoleküle einen Schritt des Auswählens von phosphoreszierenden Übertragungsmolekülen dahingehend umfasst, dass eine Übertragungsrate von Exzitonen von den elektrolumineszenten, organischen Molekülen zu den phosphoreszierenden Übertragungsmolekülen größer als eine Zerfallsrate von Exzitonen in den elektrolumineszenten, organischen Molekülen ist.

**6.** Verfahren nach Anspruch 1, wobei der Schritt des Vorsehens eines oder mehrerer phosphoreszierender Übertragungsmoleküle einen Schritt des Auswählens von phosphoreszierenden Übertragungsmolekülen dahingehend umfasst, dass eine Übertragungsrate von Exzitonen von den phosphoreszierenden Übertragungsmolekülen zu den Quantenpunkten größer als eine Zerfallsrate von Exzitonen in den phosphoreszierenden Übertragungsmolekülen ist.

**7.** Anordnung (2) von organischen Molekülen mit eingebetteten Quantenpunkten mit verbesserter Übertragung elektrischer Energie von elektrolumineszenten, organischen Molekülen (12) zu eingebetteten Quantenpunkten (14), wobei die Anordnung umfasst:

- eine Matrix (10) von mit Quantenpunkten eingebetteten, elektrolumineszenten, organischen Molekülen sowie
- einen ersten und zweiten elektrischen Kontakt (4,6), um der Matrix Elektronen und Löcher zuzuführen,

**dadurch gekennzeichnet, dass** ein Quantenpunkt ein oder mehrere phosphoreszierende Übertragungsmoleküle (15) aufweist, die an seiner Oberfläche angelagert sind, um in den elektrolumineszenten, organischen Molekülen erzeugte Exzitonen aufzunehmen und aufgenommene Exzitonen zu dem Quantenpunkt zu übertragen, wobei die phosphoreszierenden Übertragungsmoleküle so gewählt werden, dass eine Übertragungsrate von Exzitonen von den elektrolumineszenten, organischen Molekülen zu den phosphoreszierenden Übertragungsmolekülen größer als eine Zerfallsrate von Exzitonen in den elektrolumineszenten, organischen Molekülen ist.

**8.** Anordnung nach Anspruch 7, wobei das eine oder die mehreren Übertragungsmoleküle so gewählt werden, dass eine Übertragungsrate von Exzitonen von den Übertragungsmolekülen zu den Quantenpunkten größer als eine Zerfallsrate von Exzitonen in den Übertragungsmolekülen ist.

**9.** Verfahren zur Herstellung einer Licht emittierenden, organischen Anordnung (2) mit eingebetteten Quantenpunkten mit verbesserter Übertragung elektrischer Energie von elektrolumineszenten, organischen Molekülen (12) zu Quantenpunkten (14), wobei das Verfahren die folgenden Schritte umfasst:

(a) Vorsehen mehrerer elektrolumineszenter, organischer Moleküle in Lösung,
(b) Vorsehen einer Lösung, die mehrere Quantenpunkte mit an den Oberflächen angelagerten, phosphoreszierenden Übertragungsmolekülen (15) aufweist, wobei die phosphoreszierenden Übertragungsmoleküle einen Bandabstand, $E_{transfer}$, haben, welcher kleiner als ein Bandabstand, $E_{org.mol.}$, der elektrolumineszenten, organischen Moleküle und größer als ein Bandabstand, $E_{QD}$, der Quantenpunkte ist,
(c) Mischen der Lösung aus elektrolumineszenten, organischen Molekülen mit der Quantenpunktlösung,
(d) Vorsehen eines ersten elektrischen Kontakts (6),
(e) Ausbilden einer Matrix (10) von elektrolumineszenten, organischen Molekülen mit eingebetteten Quantenpunkten auf dem ersten elektrischen Kontakt durch Deponieren der Mischlösung auf dem ersten elektrischen Kontakt und
(f) Deponieren eines zweiten elektrischen Kontakts (4) auf der Matrix.

**10.** Verfahren zur Herstellung nach Anspruch 9, welches weiterhin die Schritte des Ausbildens einer Materialschicht zwischen der Matrix und der ersten oder zweiten Elektrode zur Verbesserung des Löchertransports und Verschlechterung des Elektronentransports umfasst.

**11.** Verfahren zur Herstellung nach Anspruch 9, welches weiterhin die Schritte des Ausbildens einer Materialschicht zwischen der Matrix und der zweiten oder ersten Elektrode zur Verbesserung des Elektronentransports und Verschlechterung des Löchertransports umfasst.

## Revendications

**1.** Procédé pour améliorer le transfert d'énergie électrique à partir de molécules organiques électroluminescentes (12) à des points quantiques (14) qui sont intégrés dans une matrice constituée de matière organique, le procédé comprenant les étapes suivantes consistant à:

- pourvoir de points quantiques intégrés une matrice (10) constituée de molécules organiques électroluminescentes,
- appliquer une ou plusieurs molécules phosphorescentes de transfert (15) sur les surfaces des points quantiques,
- fournir des électrons et des trous à la matrice en utilisant des premier et deuxième contacts électriques (4, 6) qui sont en contact électrique avec la matrice organique,
- générer des états excités dans la molécule organique électroluminescente de la matrice sous forme d'excitons,
- transférer des excitons à partir de la molécule organique électroluminescente aux molécules phosphorescentes sur les points quantiques, et
- transférer des excitons à partir des molécules phosphorescentes de transfert aux points quantiques.

2. Procédé selon la revendication 1, dans lequel l'étape consistant à pourvoir de points quantiques intégrés une matrice constituée de molécules organiques électroluminescentes comprend l'étape suivante consistant à préparer la matrice à partir d'une solution constituée de molécules organiques et de points quantiques.

3. Procédé selon la revendication 1, comprenant encore l'étape suivante consistant à confiner des électrons et des trous dans la matrice en fournissant des couches de blocage d'électrons et de trous qui sont adjacentes à la matrice.

4. Procédé selon la revendication 1, dans lequel l'étape consistant à fournir une ou plusieurs molécules phosphorescentes de transfert comprend une étape suivante consistant à sélectionner les molécules phosphorescentes de transfert qui présentent un intervalle de bande $E_{transfer}$ qui est inférieur à un intervalle de bande $E_{org.\ mol.}$ des molécules organiques électroluminescentes et qui est supérieur à un intervalle de bande $E_{QD}$ des points quantiques.

5. Procédé selon la revendication 1, dans lequel l'étape consistant à fournir une ou plusieurs molécules phosphorescentes de transfert comprend une étape suivante consistant à sélectionner les molécules phosphorescentes de transfert de manière à ce que le taux de transfert d'excitons à partir des molécules organiques électroluminescentes aux molécules phosphorescentes de transfert soit supérieur à un taux de décroissance d'excitons dans les molécules organiques électroluminescentes.

6. Procédé selon la revendication 1, dans lequel l'étape consistant à fournir une ou plusieurs molécules phosphorescentes de transfert comprend une étape suivante consistant à sélectionner les molécules phosphorescentes de transfert de manière à ce qu'un taux de transfert d'excitons à partir des molécules phosphorescentes de transfert aux points quantiques soit supérieur à un taux de décroissance d'excitons dans les molécules phosphorescentes de transfert.

7. Dispositif de molécules organiques intégrées par point quantique (2) avec un transfert amélioré d'énergie électrique à partir des molécules organiques électroluminescentes (12) aux points quantiques intégrés (14), le dispositif comprenant:

- une matrice (10) constituée de molécules organiques électroluminescentes qui sont intégrées avec des points quantiques, et
- des premier et deuxième contacts électriques (4, 6) pour fournir des électrons et des trous à la matrice,

**caractérisé en ce qu'**un point quantique présente une ou plusieurs molécules phosphorescentes de transfert (15) qui sont attachées à sa surface pour recevoir les excitons qui sont générés dans les molécules organiques électroluminescentes et pour transférer les excitons reçus au point quantique, les molécules phosphorescentes de transfert étant choisies de manière à ce qu'un taux de transfert d'excitons à partir des molécules organiques électroluminescentes aux molécules phosphorescentes de transfert soit supérieur à un taux de décroissance d'excitons dans les molécules organiques électroluminescentes.

8. Dispositif selon la revendication 7, dans lequel l'une ou les plusieurs molécules de transfert sont choisies de manière à ce qu'un taux de transfert d'excitons à partir des molécules de transfert aux points quantiques soit supérieur à un taux de décroissance d'excitons dans les molécules de transfert.

9. Processus de fabrication d'un dispositif luminescent de molécules organiques intégrées par point quantique (2) avec un transfert amélioré d'énergie électrique à partir des molécules organiques électroluminescentes (12) aux points quantiques intégrés (14), le processus comprenant les étapes suivantes consistant à:

a) fournir une pluralité de molécules organiques électroluminescentes en solution,
b) fournir une solution comprenant une pluralité de points quantiques avec des molécules phosphorescentes de transfert (15) qui sont attachées aux surfaces, les molécules phosphorescentes de transfert ayant un intervalle de bande $E_{transfer}$ qui est inférieur à un intervalle de bande $E_{org.\ mol.}$ des molécules organiques électroluminescentes et qui est supérieur à un intervalle de bande $E_{QD}$ des points quantiques,
c) mélanger la solution de molécules organiques électroluminescentes avec la solution de points quantiques,
d) fournir un premier contact électrique (6),
e) former une matrice (10) constituée de molécules organiques électroluminescentes avec des points quantiques intégrés sur le premier contact électrique en déposant la solution mélangée sur le premier contact électrique, et

f) déposer un deuxième contact électrique (4) sur la matrice.

10. Processus de fabrication selon la revendication 9, comprenant encore les étapes suivantes consistant à constituer, entre la matrice et la première ou la deuxième électrode, une couche matérielle pour améliorer le transport de trous et pour détériorer le transport d'électrons.

11. Processus de fabrication selon la revendication 9, comprenant encore les étapes suivantes consistant à constituer, entre la matrice et la deuxième ou la première électrode, une couche matérielle pour améliorer le transport d'électrons et pour détériorer le transport de trous.

FIG.1

FIG.2

FIG.3

FIG.4A

FIG.4B

FIG.4C

FIG.4D

FIG.4E

FIG.4F

FIG.4G

FIG.4H

FIG.4I

$R = SH, NH_2$

FIG.4J

FIG.5

## FIG.6

## FIG.7

FIG.8

FIG.9

FIG.10

FIG.11

FIG.12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03021694 A

- WO 03084292 A

**Non-patent literature cited in the description**

- Quantum dot leap. *The Engineer,* 2002, vol. 291, ISSN 0013-7758, 19